# EUROPEAN PATENT APPLICATION

(11) **EP 4 770 390 A1**
(43) Date of publication of application: **01.07.2026**
(21) Application number: 25214897.8
(22) Date of filing: 11.11.2025
(51) Int. Cl.: H10K 59/40, H10K 59/50, H10K 59/80

(54) **LIGHT EMITTING DIODE DISPLAY DEVICE**

(30) Priority: 27.12.2024 KR 20240198586
(71) Applicant: LG Display Co., Ltd., Seoul, 07336 (KR)
(72) Inventor: LEE, Dae-Heung, 10845 Paju-si, Gyeonggi-do (KR)
(74) Representative: Viering, Jentschura & Partner mbB Patent- und Rechtsanwälte

(57) **Abstract**

A display device (100, 200, 300, 400) includes a display panel (101) including a light emitting diode (D) in each of first to third emission areas (EA1, EA2, EA3) of first to third pixel regions (P1, P2, P3); a transmittance variable layer (175, 275) on the display panel (101) and including first to third spacers (180a, 180b, 180c; 280a, 280b, 280c; 380a, 380b, 380c) and a light absorbing layer (178, 278) in a space between the first to third spacers (180a, 180b, 180c; 280a, 280b, 280c; 380a, 380b, 380c) or at a side surface of each spaces, the first to third spacers (180a, 180b, 180c; 280a, 280b, 280c; 380a, 380b, 380c) respectively in the first to third emission areas (EA1, EA2, EA3); a driving electrode layer (171, 271, 471) at one side of the transmittance variable layer (175, 275) and including first and second driving electrodes (172, 272, 472; 173, 273, 473) respectively in first and second non-emission areas (NEA1, NEA2); and a touch electrode layer (181, 281, 481) at the other side of the transmittance variable layer (175, 275) and including first and second touch electrodes (182, 282, 482; 183, 283, 483) respectively corresponding to the first and second driving electrodes (172, 272, 472; 173, 273, 473). This configuration enables control of light transmittance to reduce ambient light reflection while maintaining display brightness and integrating touch sensing functionality.

## Description

### BACKGROUND

### Technical Field

The present disclosure relates to a light emitting diode display device, and more specifically, to a light emitting diode display device being capable of minimizing or preventing an ambient light reflection without brightness degradation.

### Description of the Related Art

As the large-area display device is developed, the demand for the flat display device with small space occupancy is increasing. As one type of the flat display device, the technology of an organic light emitting display device including an organic light emitting diode (OLED) and an inorganic light emitting display device including an inorganic light emitting diode is developing rapidly.

For example, in the organic light emitting display device, holes from an anode and electrons from a cathode are combined to generate an exciton in an organic light emitting layer, and the exciton is transformed from an excited state to a ground state. As a result, the light is emitted from the OLED.

### BRIEF SUMMARY

Unlike a liquid crystal display device, the light emitting diode display device may not require a polarizer. However, in the organic light emitting display device without a polarizer, a problem of display quality degradation due to an ambient (or external) light reflection occurs. Therefore, in order to minimize ambient light reflection, the organic light emitting display device may include a polarizer on the display surface.

In the organic light emitting display device with the polarizer, the ambient light reflection can be minimized, but a problem of brightness degradation occurs due to the polarizer. The present disclosure is directed to a light emitting diode display device that substantially obviates one or more of the problems associated with the limitations and disadvantages of the related conventional art.

Various embodiments of the present disclosure provide a light emitting diode display device being capable of minimizing or preventing an ambient light reflection without brightness degradation.

Additional features and advantages of the present disclosure are set forth in the description which follows, and will be apparent from the description, or evident by practice of the present disclosure. The objectives and other advantages of the present disclosure are realized and attained by the features described herein as well as in the appended drawings.

To achieve these and other advantages in accordance with the embodiments of the present disclosure, as described herein, an aspect of the present disclosure is a light emitting diode display device comprising a display panel including first, second and third pixel regions and a light emitting diode in each of a first emission area of the first pixel region, a second emission area of the second pixel region and a third emission area of the third pixel region; a transmittance variable layer disposed on the display panel and including first, second and third spacers and a light absorbing layer in a space between the first to third spacers or at a side surface of each of the first to third spacers, the first to third spacers respectively disposed in the first, second and third emission areas; a driving electrode disposed at one side of the transmittance variable layer and including a first driving electrode in a first non-emission area between the first and second emission areas and a second driving electrode in a second non-emission area between the second and third emission areas; and a touch electrode layer disposed at the other side of the transmittance variable layer and including a first touch electrode corresponding to the first driving electrode and a second touch electrode corresponding to the second driving electrode. Further embodiments are described in the dependent claims.

It is to be understood that both the foregoing general description and the following detailed description are exemplary and explanatory and are intended to further explain the present disclosure as claimed.

### BRIEF DESCRIPTION OF THE SEVERAL VIEWS OF THE DRAWINGS

The accompanying drawings, which are included to provide a further understanding of the present disclosure and are incorporated in and constitute a part of this specification, illustrate embodiments of the present disclosure and together with the description serve to explain the principles of the present disclosure.
FIG. 1 is a schematic circuit diagram of a light emitting diode display device according to an embodiment of the present disclosure.
FIGs. 2A and 2B are schematic plane views illustrating a light emitting diode display device according to a first embodiment of the present disclosure.
FIGs. 3A and 3B are schematic cross-section views illustrating the light emitting diode display device according to the first embodiment of the present disclosure.
FIG. 4 is a schematic cross-section view of a display panel of the light emitting diode display device according to the first embodiment of the present disclosure.
FIG. 5 is a schematic cross-section view of an organic light emitting display device according to a second embodiment of the present disclosure.
FIG. 6 is a schematic cross-section view of an organic light emitting display device according to a third embodiment of the present disclosure.
FIG. 7 is a schematic cross-section view of an organic light emitting display device according to a fourth embodiment of the present disclosure.

### DETAILED DESCRIPTION

Reference will now be made in detail to aspects of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present disclosure and methods of achieving them will be apparent with reference to the aspects described below in detail with the accompanying drawings. However, the present disclosure is not limited to the aspects disclosed below, but can be realized in a variety of different forms, and only these aspects allow the disclosure of the present disclosure to be complete. The present disclosure is provided to fully inform the scope of the disclosure to the skilled in the art of the present disclosure.

The shapes, sizes, proportions, angles, numbers, and the like disclosed in the drawings for explaining the aspects of the present disclosure are illustrative, and the present disclosure is not limited to the illustrated matters. The same reference numerals refer to the same elements throughout the specification. In addition, in describing the present disclosure, if it is determined that a detailed description of the related known technology unnecessarily obscure the subject matter of the present disclosure, the detailed description thereof can be omitted. When 'including', 'having', 'consisting', and the like are used in this specification, other parts may be added unless 'only' is used. When a component is expressed in the singular, cases including the plural are included unless specific statement is described.

As used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

The expression "at least one of a, b, and c" described throughout the specification can encompass 'a alone', 'b alone', 'c alone', 'a and b', 'a and c', 'b and c', or 'all of a, b, and c'. The advantages and features of the present disclosure, and the methods for achieving them, will become apparent by referring to the embodiments described in detail below together with the accompanying drawings.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

The area, length, or thickness of each component described in the specification is illustrated for convenience of explanation, and the present disclosure is not necessarily limited to the area and thickness of the illustrated component.

It will be understood that, although the terms "first," "second," etc., may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various aspects of the present disclosure may be partially or overall coupled to or combined with each other, and may be variously inter-operated with each other and driven technically as those skilled in the art can sufficiently understand. The aspects of the present disclosure may be carried out independently from each other, or may be carried out together in co-dependent relationship.

Without specific description, a transistor constituting the pixel circuit of the present disclosure may include at least one of an oxide thin film transistor (Oxide TFT), an amorphous silicon TFT (a-Si TFT), and a low temperature poly silicon (LTPS) TFT.

The following embodiments are described with reference to organic light emitting diode display devices. However, the embodiment of the present disclosure is not limited to organic light emitting diode display devices. For example, a display device according to an embodiment of the present disclosure may be an organic light emitting diode display device using an organic light emitting material or an inorganic light emitting diode display device using an inorganic light emitting material such as a quantum dot. Namely, the light emitting diode display device of the present disclosure may be an organic light emitting diode display device or an inorganic light emitting diode display device.

Reference will now be made in detail to some of the examples and preferred embodiments, which are illustrated in the accompanying drawings.

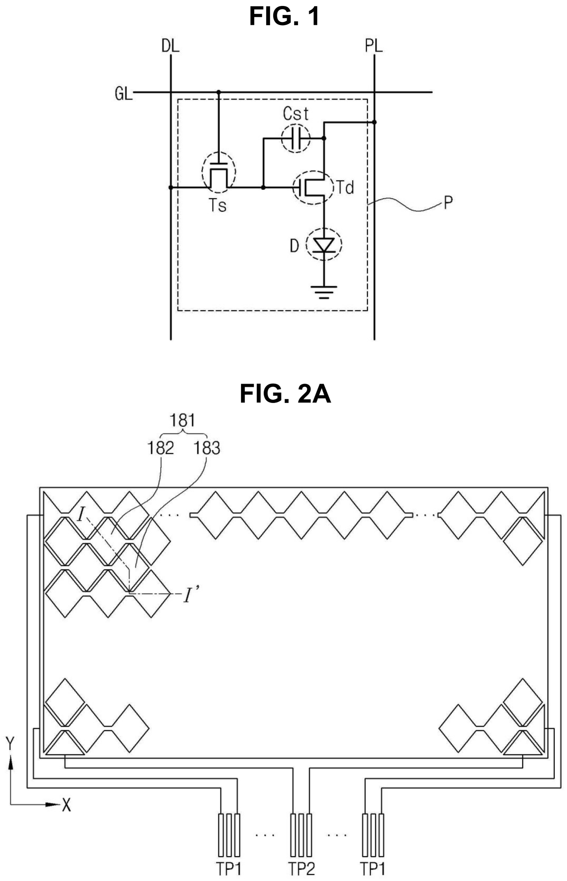

FIG. 1 is a schematic circuit diagram of an organic light emitting diode display device according to an embodiment of the present disclosure.

As shown in FIG. 1, an organic light emitting display device includes a gate line GL, a data line DL and a power line PL. The gate line GL, the data line DL and the power line PL cross each other to define a pixel region P. In the pixel region P, a switching thin film transistor TFT Ts, a driving TFT Td, a storage capacitor Cst and an OLED D are disposed. The pixel region may include a red pixel region, a green pixel region and a blue pixel region.

The switching TFT Ts is connected to the gate line GL and the data line DL, and the driving TFT Td and the storage capacitor Cst are connected to the switching TFT Ts and the power line PL. The OLED D is connected to the driving TFT Td.

In the organic light emitting display device, when the switching TFT Ts is turned on by a gate signal applied through the gate line GL, a data signal from the data line DL is applied to the gate electrode of the driving TFT Td and an electrode of the storage capacitor Cst.

When the driving TFT Td is turned on by the data signal, an electric current is supplied to the OLED D from the power line PL. As a result, the OLED D emits light. In this case, when the driving TFT Td is turned on, a level of an electric current applied from the power line PL to the OLED D is determined such that the OLED D can produce a gray scale.

The storage capacitor Cst serves to maintain the voltage of the gate electrode of the driving TFT Td when the switching TFT Ts is turned off.

Accordingly, even if the switching TFT Ts is turned off, a level of an electric current applied from the power line PL to the OLED D is maintained to next frame. As a result, the organic light emitting display device displays a desired image.

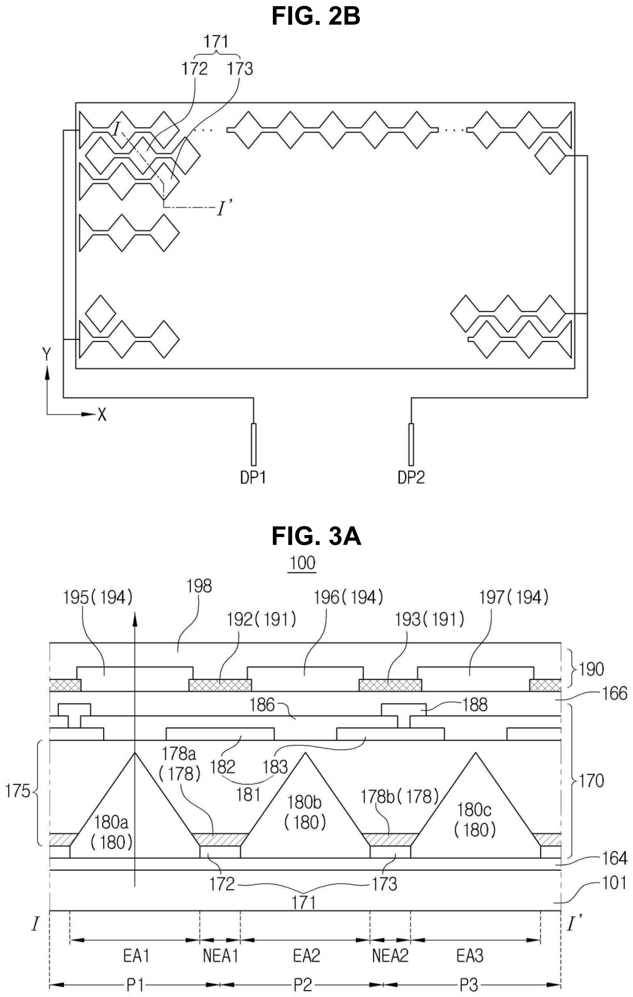

FIGs. 2A and 2B are schematic plane views illustrating a light emitting diode display device according to a first embodiment of the present disclosure. In more detail, FIG. 2A is a schematic plane view showing a touch electrode layer of a transmittance variable touch panel, and FIG. 2B is a schematic plane view showing a driving electrode layer of the transmittance variable touch panel.

The light emitting diode display device of the present disclosure includes a display panel including a light emitting diode and a transmittance variable touch panel disposed over the display panel. The transmittance variable touch panel includes a transmittance variable layer, a touch electrode layer at one side of the transmittance variable layer and a driving electrode layer at the other one side of the transmittance variable layer.

As shown in FIG. 2A, the touch electrode layer 181 includes a first touch electrode row including a plurality of first touch electrodes 182 and a second touch electrode row including a second touch electrodes 183. The first touch electrodes 182 are arranged along a first direction X. The second touch electrode row is spaced apart from the first touch electrode row along a second direction Y, and the second touch electrodes 183 are arranged along the first direction X. The first and second directions X and Y may be perpendicular to each other. The touch electrode layer 181 may be disposed on the transmittance variable layer 175 (of FIG. 3A).

The first touch electrodes 182 in the first touch electrode row are connected to each other, and the second touch electrodes 183 in the second touch electrode row are connected to each other.

Each of a plurality of first touch electrode rows is connected to a first touch electrode pad TP1 through a connection line at an end of the first direction X. The second touch electrodes 183 in each of the second touch electrode rows are connected through a bridge electrode and are connected to a second touch electrode pad TP2 through a connection line at an end of the second direction Y.

As shown in FIG. 2B, the driving electrode layer 171 includes a first driving electrode row including a plurality of first driving electrodes 172 and a second driving electrode row including a plurality of second driving electrodes 173. The first driving electrodes 172 are arranged along a first direction X. The second driving electrode row is spaced apart from the first driving electrode row along a second direction Y, and the second driving electrodes 173 are arranged along the first direction X. The driving electrode layer 171 may be disposed on a first buffer layer 164 (of FIG. 3A).

The first driving electrodes 172 in the first driving electrode row are connected to each other, and the second driving electrodes 173 in the second driving electrode row are connected to each other.

Each of a plurality of first driving electrode rows is connected to a first driving electrode pad DP1 through a connection line at an end of the first direction X. The second driving electrodes 173 in each of the second driving electrode rows are connected through a bridge electrode and are connected to a second driving electrode pad DP2 through a connection line at an end of the second direction Y.

The first touch electrode 182 corresponds to and overlaps the first driving electrode 172, and the second touch electrode 183 corresponds to and overlaps the second driving electrode 173. For example, the first touch electrode 182 may be disposed over the first driving electrode 172 and may have a width (or an area) equal to or greater than the first driving electrode 172. The second touch electrode 183 may be disposed over the second driving electrode 173 and may have a width (or an area) equal to or greater than the second driving electrode 173.

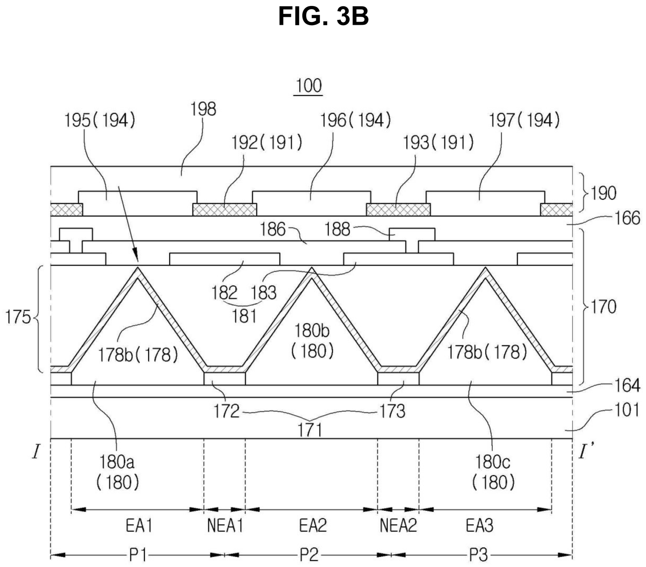

FIGs. 3A and 3B are schematic cross-section views illustrating the light emitting diode display device according to the first embodiment of the present disclosure. In more detail, FIGs. 3A and 3B are schematic cross-section views taken along the line I-I' of FIG. 2A or FIG. 2B and respectively shows an on state and an off state of the light emitting diode display device.

As shown in FIGs. 3A and 3B, the light emitting diode display device 100 includes a display panel 101 and a transmittance variable touch panel 170 disposed over the display panel 101.

In addition, the light emitting diode display device 100 may further include a color filter panel 190 disposed over the transmittance variable touch panel 170. Namely, the transmittance variable touch panel 170 may be positioned between the display panel 101 and the color filer panel 190.

Moreover, the light emitting diode display device 100 may further include at least one of a first buffer layer 164 between the display panel 101 and the transmittance variable touch panel 170 and a second buffer layer 166 between the transmittance variable touch panel 170 and the color filter panel 190. Each of the first and second buffer layers 164 and 166 may be formed of an inorganic insulating material, *e.g.,* silicon oxide or silicon nitride, or an organic insulating material, *e.g.,* photo-aryl or benzocyclobutene, and may have a single-layered structure or a multi-layered structure.

The display panel 101 may be an organic light emitting diode display panel or an inorganic light emitting diode display panel.

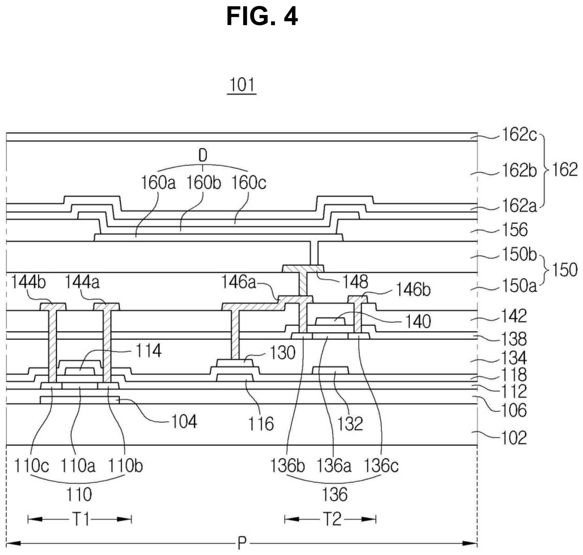

Referring to FIG. 4, which is a schematic cross-section view of a display panel of the light emitting diode display device according to the first embodiment of the present disclosure, the display panel 101 includes a substrate 102 including a pixel region P and a light emitting diode D corresponding to the pixel region P and disposed over the substrate 102.

The pixel region P may include first, second and third pixel regions P1, P2 and P3. The first pixel region P1 may be a red pixel region, the second pixel region P2 may be a green pixel region and a third pixel region P3 may be a blue pixel region.

Each of the first to third pixel regions P1, P2 and P3 may include an emission area and a non-emission area. For example, a first emission area EA1 of the first pixel region P1, a second emission area EA2 of the second pixel region P2, a third emission area EA of the third pixel region P3, a first non-emission area NEA1 between the first and second emission areas EA1 and EA2, a second non-emission area NEA2 between the second and third emission areas EA2 and EA3 and a third non-emission area between the first and third emission areas EA1 and EA3 may be defined on the substrate 102.

The substrate 102 may be a glass substrate or a plastic substrate. For example, the substrate 102 may be one of polyimide (PI) substrate, polyethersulfone (PES) substrate, polyethylenenaphthalate (PEN) substrate, polyethylene terephthalate (PET) substrate and polycarbonate (PC) substrate.

In an exemplary embodiment of the present disclosure, the substrate may have a triple-layered structure including a first polyimide layer, a second polyimide layer and an interlayer inorganic layer between the first and second polyimide layers. The interlayer inorganic layer may be formed of an inorganic insulating material, *e.g.,* silicon oxide or silicon nitride.

A first light shielding pattern 104 is disposed on the substrate 102. The light through the substrate 104 can be blocked by the first light shielding pattern 104. For example, the first light shielding pattern 104 may be formed of a metallic material, *e.g.,* molybdenum (Mo), aluminum (Al), chromium (Cr), gold (Au), titanium (Ti), nickel (Ni), neodymium (Nd), copper (Cu) or their alloy, and have a single-layered structure or a multi-layered structure.

A buffer layer, which is formed of an inorganic insulating material, *e.g.,* silicon oxide or silicon nitride, may be disposed between the substrate 102 and the first light shielding pattern 104.

A third buffer layer 106 covering the first light shielding pattern 104 is disposed over the substrate 102. The moisture and/or oxygen can be blocked by the third buffer layer 106. For example, the third buffer layer 106 may be formed of an inorganic insulating material, *e.g.,* silicon oxide or silicon nitride, and have a single-layered structure or a multi-layered structure. When the first light shielding pattern 104 is omitted, the third buffer layer 106 may be directly formed on the substrate 102 and contact the substrate 102.

A first semiconductor layer 110 corresponding to the first light shielding pattern 104 is disposed on the third buffer layer 106. The first semiconductor layer 110 may include one of a poly-semiconductor material, an amorphous semiconductor material and an oxide semiconductor material. When the first light shielding pattern 104 and the third buffer layer 106 are omitted, the first semiconductor layer 110 may be directly disposed on the substrate 102.

In an exemplary embodiment of the present disclosure, the first semiconductor layer 110 may be formed of a poly-semiconductor material, e.g., polycrystalline silicon. The first semiconductor layer 110 may include a first channel region 110a, a first source region 110b at one side of the first channel region 110a and a first drain region 110c at the other side of the first channel region 110a. Impurities may be doped into the first source and drain regions 110b and 110c.

A first gate insulating layer 112 covering the first semiconductor layer 110 is disposed over the third buffer layer 106. The first gate insulating layer 112 may be formed of an inorganic insulating material, *e.g.,* silicon oxide or silicon nitride, and have a single-layered structure or a multi-layered structure.

A first gate electrode 114 corresponding to the first channel region 110a of the first semiconductor layer 110 is disposed on the first gate insulating layer 112. In addition, a first capacitor electrode 116, which is spaced apart from the first gate electrode 114, is disposed on the first gate insulating layer 112.

The first gate electrode 114 and the first capacitor electrode 116 may be disposed on the same layer and be formed of the same material. For example, each of the first gate electrode 114 and the first capacitor electrode 116 may be formed of a metallic material, *e.g.,* Mo, Al, Cr, Au, Ti, Ni, Nd, Cu or their alloy, and have a single-layered structure or a multi-layered structure.

A first interlayer insulating layer 118 covering the first gate electrode 114 and the first capacitor electrode 116 is disposed on the first gate insulating layer 112. The first interlayer insulating layer 118 may be formed of an inorganic insulating material, *e.g.,* silicon oxide or silicon nitride, and have a single-layered structure or a multi-layered structure.

A second capacitor electrode 130 corresponding to the first capacitor electrode 116 and a second light shielding pattern 132 spaced apart from the second capacitor electrode 130 are disposed on the first interlayer insulating layer 118.

The second capacitor electrode 130 and the second light shielding pattern 132 may be disposed on the same layer and be formed of the same material. For example, each of the second capacitor electrode 130 and the second light shielding pattern 132 may be formed of a metallic material, *e.g.,* Mo, Al, Cr, Au, Ti, Ni, Nd, Cu or their alloy, and have a single-layered structure or a multi-layered structure.

A second interlayer insulating layer 134 covering the second capacitor electrode 130 and the second light shielding pattern 132 is disposed on the first interlayer insulating layer 118. The external moisture and/or oxygen can be blocked by the second interlayer insulating layer 134. For example, the second interlayer insulating layer 134 may be formed of an inorganic insulating material, e.g., silicon oxide or silicon nitride, or an organic insulating material, *e.g.,* photo-acryl or benzocyclobutene (BCB), and have a single-layered structure or a multi-layered structure.

A second semiconductor layer 136 corresponding to the second light shielding pattern 132 is disposed on the second interlayer insulating layer 134. The second semiconductor layer 136 may include one of a poly-semiconductor material, an amorphous semiconductor material and an oxide semiconductor material.

In an exemplary embodiment of the present disclosure, the second semiconductor layer 136 may be formed of an oxide semiconductor material, *e.g.,* indium-gallium-zinc oxide (IGZO), zinc oxide (ZnO), tin oxide (SnO2), copper oxide (Cu2O), nickel oxide (NiO), indium-tin-zinc oxide (ITZO) or indium-aluminum-zinc oxide (IAZO).

The second semiconductor layer 136 may include a second channel region 136a, a second source region 136b at one side of the second channel region 136a and a second drain region 136c at the other side of the second channel region 136a. Impurities may be doped into the second source and drain regions 136b and 136c.

A second gate insulating layer 138 covering the second semiconductor layer 136 is disposed over the second interlayer insulating layer 134. The second gate insulating layer 138 may be formed of an inorganic insulating material, *e.g.,* silicon oxide or silicon nitride, and have a single-layered structure or a multi-layered structure.

A second gate electrode 140 corresponding to the second channel region 136a of the second semiconductor layer 136 is disposed on the second gate insulating layer 138. For example, the second gate electrode 140 may be formed of a metallic material, *e.g.,* Mo, Al, Cr, Au, Ti, Ni, Nd, Cu or their alloy, and have a single-layered structure or a multi-layered structure.

A third interlayer insulating layer 142 covering the second gate electrode 140 is disposed on the second gate insulating layer 138. The third interlayer insulating layer 142 may be formed of an inorganic insulating material, *e.g.,* silicon oxide or silicon nitride, and have a single-layered structure or a multi-layered structure.

A first source electrode 144a, a first drain electrode 144b, a second source electrode 146a and a second drain electrode 146b are disposed on the third interlayer insulating layer 142.

The first source electrode 144a and the first drain electrode 144b are respectively connected to the first source region 110b and the first drain region 110c via contact holes through the third interlayer insulating layer 142, the second gate insulating layer 138, the second interlayer insulating layer 134, the first interlayer insulating layer 118 and the first gate insulating layer 112. The first source electrode 144a is connected to the first capacitor electrode 116 via a contact hole through the third interlayer insulating layer 142, the second gate insulating layer 138, the second interlayer insulating layer 134 and the first interlayer insulating layer 118.

The second source electrode 146a and the second drain electrode 146b are respectively connected to the second source region 136b and the second drain region 136c via contact holes through the third interlayer insulating layer 142 and the second gate insulating layer 138. The second source electrode 146a is connected to the second capacitor electrode 130 via a contact hole through the third interlayer insulating layer 142, the second gate insulating layer 138 and the second interlayer insulating layer 134.

The first source and drain electrodes 144a and 144b and the second source and drain electrodes 146a and 146b may be disposed on the same layer and formed of the same material. For example, each of the first source and drain electrodes 144a and 144b and the second source and drain electrodes 146a and 146b may be formed of a metallic material, *e.g.,* Mo, Al, Cr, Au, Ti, Ni, Nd, Cu or their alloy, and have a single-layered structure or a multi-layered structure.

The first semiconductor layer 110, the first gate electrode 114, the first source electrode 144a and the first drain electrode 144b constitute a first TFT T1, and the second semiconductor layer 136, the second gate electrode 140, the second source electrode 146a and the second drain electrode 146b constitute a second TFT T2. For example, the first TFT T1 may be a switching TFT, and the second TFT may be a driving TFT. In addition, the first and second capacitor electrodes 116 and 130 constitute a storage capacitor.

The display panel 101 of the present disclosure includes the first and second TFTs T1 and T2. Each of the first semiconductor layer 110 of the first TFT T1 and the second semiconductor layer 136 of the second TFT T2 may include one of a poly-semiconductor material, an amorphous semiconductor material and an oxide semiconductor material, and at least one of the first semiconductor layer 110 of the first TFT T1 and the second semiconductor layer 136 of the second TFT T2 may include the oxide semiconductor material. In an exemplary embodiment of the present disclosure, the first semiconductor layer 110 of the first TFT T1 may be formed of the poly-semiconductor material, *e.g.,* polycrystalline silicon, and the second semiconductor layer 136 of the second TFT T2 may be formed of the oxide semiconductor material.

In FIG. 4, the first gate electrode 114, the first source electrode 144a and first drain electrode 146a are disposed over the first semiconductor layer 110, and the second gate electrode 140, the second source electrode 146a and the second drain electrode 146b are disposed over the second semiconductor layer 136. Namely, each of the first and second TFTs T1 and T2 has a coplanar structure. Alternatively, in each of the first and second TFTs T1 and T2, a gate electrode may be disposed under a semiconductor layer, and a source and a drain electrode may be disposed over the semiconductor layer. Namely, each of the TFTs T1 and T2 may have an inverted-staggered structure.

A planarization layer 150 covering the first source and drain electrodes 144a and 144b and the second source and drain electrodes 146a and 146b is disposed on the third interlayer insulating layer 142.

The planarization layer 150 may be formed of an organic insulating material, e.g., photo-aryl or BCB.

The planarization layer 150 may include a first planarization layer150a on the first source and drain electrodes 144a and 144b and the second source and drain electrodes 146a and 146b and a second planarization layer150b on the first planarization layer150a.

A connection electrode 148 corresponding to the second source electrode 146a is disposed on the first planarization layer150a. The connection electrode 148 may connected to the second source electrode 146a through a contact hole in the first planarization layer150a. For example, the connection electrode 148 may be formed of a metallic material, *e.g.,* Mo, Al, Cr, Au, Ti, Ni, Nd, Cu or their alloy, and have a single-layered structure or a multi-layered structure.

The second planarization layer150b is disposed on the first planarization layer150a to cover the connection electrode 148, and a first electrode 160a is disposed on the second planarization layer150b. The first electrode 160a corresponds to the connection electrode 148 and is connected to the connection electrode 148 through a contact hole in the second planarization layer150b.

For example, the first electrode 160a is separately formed in each pixel region P. The first electrode 160a may be an anode and may include a transparent conductive oxide (TCO) layer, which is formed of a conductive material, e.g., a transparent conductive oxide material, having a relatively high work function, and a reflective layer.

For example, the transparent conductive oxide material may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO), and the reflective layer may include at least one of silver (Ag), an alloy of Ag and one of palladium (Pd), Cu, In and Nd and aluminum-palladium-copper alloy (APC). For example, the first electrode 160a may have a double-layered structure of Ag/ITO or APC/ITO or a triple-layered structure of ITO/Ag/ITO or ITO/APC/ITO.

A bank 156 is formed on the second planarization layer150b at a boundary of the pixel region. The bank 156 covers an edge of the first electrode 160a and has a first opening to expose a center of the first electrode 160a. The bank 156 may extend into a portion of the non-display area NDA. The bank 156 may include a light-absorbing particle, *e.g.,* a black particle, to have a light-absorbing property.

A spacer is disposed on the bank 156. For example, each of the bank 156 and the spacer may include an organic insulating material, *e.g.,* photo-acryl, benzocyclobutene (BCB) or polyimide.

A light emitting layer 160b covering the first electrode 160a and the bank 156 is disposed. The light emitting layer 160b contacts the first electrode 160a in the first opening of the bank 156. Namely, the light emitting layer 160b may be formed to contact an upper surface of the first electrode 160a and a side surface and an upper surface of the bank 156.

For example, the light emitting layer 160b may include an organic emitting material layer (EML) including a host and a dopant or an inorganic emitting material layer including a quantum dot. In addition, the light emitting layer 160b may further include at least one of a hole injection layer (HIL), a hole transporting layer (HTL), an electron blocking layer (EBL), a hole blocking layer (HBL), an electron transporting layer (ETL) and an electron injection layer (EIL) to have a multi-layered structure.

A second electrode 160c is formed over the substrate 102 where the organic emitting layer 160b is formed. The second electrode 160c covers an entire surface of the display area. The second electrode 160c may be formed of at least one of ITO, IZO, Al, Ag, Cu, Pb, magnesium (Mg), Mo, Ti and their alloy and have a single-layered structure or a multi-layered structure. The second electrode 160c may have a thin profile (small thickness) to provide a light transmittance property (or a semi-transmittance property).

The first electrode 160a, the light emitting layer 160b and the second electrode 160c constitute a light emitting diode D. The light emitting diode D may emit the red, green and blue light in the red, green and blue pixel region, respectively.

In the display panel 101, the light from the light emitting layer 160b passes through the second electrode 160c to display an image. Namely, the organic light emitting display panel 101 of the present disclosure is a top-emission type display panel.

An encapsulation layer (or encapsulation film) 162 is formed on the second electrode 160c to prevent penetration of moisture into the light emitting diode D. The encapsulation layer 162 may cover an entire substrate 102. The encapsulation layer 162 includes a first inorganic insulating layer 162a, an organic insulating layer 162b and a second inorganic insulating layer 162c sequentially stacked, but it is not limited thereto.

Each of the first and second inorganic insulating layers 162a and 162c may be formed of an inorganic insulating material, *e.g.,* silicon oxide or silicon nitride. The organic insulating layer 162b may be formed of an organic insulating material, *e.g.,* acryl resin, epoxy resin, phenolic resin, polyamide resin or polyimide resin.

Referring again to FIGs. 3A and 3B, the first buffer layer 164 is disposed on the display panel 101, and the transmittance variable touch panel 170 is disposed on the first buffer layer 164.

The transmittance variable touch panel 170 includes a transmittance variable layer 175 including a spacer 180 and a light absorbing layer 178, a driving electrode layer 171 and a touch electrode layer 181.

The spacer 180 includes a first spacer 180a in the first emission area EA1, a second spacer 180b in the second emission area EA2 and a third spacer 180c in the third emission area EA3. The first to third spacers 180a, 180b and 180c are spaced apart from each other. A space between the first and second spacers 180a and 180b may correspond to the first non-emission area NEA1, and a space between the second and third spacers 180b and 180c may correspond to the second emission area NEA2. A spacer between the first and third spacers 180a and 180c may correspond to the third non-emission area.

Each of the first to third spacers 180a, 180b and 180c has a lower portion having a first width and an upper portion having a second width. The second width is smaller than the first width. For example, each of the first to third spacers 180a, 180b and 180c may have a triangular cone shape.

Each of the first to third spacers 180a, 180b and 180c may be formed of an organic insulating material, e.g., acryl resin, epoxy resin, phenolic resin, polyamide resin or polyimide resin.

The light absorbing layer 178 is disposed in a space between adjacent two of the first to third spacers 180a, 180b and 180c or at a side surface of each of the first to third spacers 180a, 180b and 180c. Namely, the light absorbing layer 178 is positioned in the first non-emission area NEA1, the second non-emission area NEA2 and the third non-emission area or covers the side surface of each of the first to third spacers 180a, 180b and 180c.

The light absorbing layer 178 includes a charged black particle. The light absorbing layer 178 is positioned in the emission areas EA1, EA2 and EA3 or the non-emission areas NEA1 and NEA2 according to the operation (or drive) of the transmittance variable touch panel 170 so that the transmittance of the transmittance variable touch panel 170 and the light emitting diode display device 100 can be controlled.

The light absorbing layer 178 may include a first light absorbing layer 178a positioned in the first non-emission area NEA1 or one side surface of the first spacer 180a and one side surface of the second spacer 180b and a second light absorbing layer 178b positioned in the second non-emission area NEA2 or one side surface of the second spacer 180b and one side surface of the third spacer 180c.

The driving electrode layer 171 is positioned at one side of the transmittance variable layer 175. For example, the driving electrode layer 171 may be positioned at a lower side of the transmittance variable layer 175.

The driving electrode layer 171 is positioned on the first buffer layer 164 and in the non-emission areas NEA1 and NEA2. The driving electrode layer 171 may include a first driving electrode 172 positioned in the first non-emission area NEA1 and a second driving electrode 173 positioned in the second non-emission area NEA2. The driving electrode layer 171 may further include a third driving electrode positioned in the third non-emission area. The driving electrode layer 171 is positioned under the light absorbing layer 178 and overlaps the light absorbing layer 178.

The driving electrode 171 is positioned between adjacent spacers 180. The first driving electrode 172 is positioned between the first and second spacers 180a and 180b, and the second driving electrode 173 is positioned between the second and third spacers 180b and 180c. The third driving electrode may be positioned between the first and third spacers 180a and 180c.

The spacer 171 may be positioned at the same layer as the spacer 180. Namely, each of the driving electrode 171 and the spacer 180 may be positioned on the first buffer layer 164.

Each of the first and second driving electrodes 172 and 173 is formed of a conductive material. For example, each of the first and second driving electrodes 172 and 173 may be formed of at least one of molybdenum (Mo), aluminum (Al), chromium (Cr), gold (Au), titanium (Ti), nickel (Ni), neodymium (Nd), copper (Cu), indium-tin-oxide (ITO), indium-zinc-oxide (IZO), indium-tin-zinc oxide (ITZO), tin oxide (SnO), zinc oxide (ZnO), indium-copper-oxide (ICO), and aluminum:zinc oxide (Al:ZnO; AZO).

The touch electrode layer 181 is positioned at the other side of the transmittance variable layer 175. For example, the touch electrode layer 181 may be positioned at an upper side of the transmittance variable layer 175.

The touch electrode layer 181 is positioned in the non-emission areas NEA1 and NEA2. The touch electrode layer 181 may include a first touch electrode 182 in the first non-emission area NEA1 and a second touch electrode 183 in the second non-emission area NEA2. The touch electrode layer 181 may further include a third touch electrode in the third non-emission area.

The first touch electrode 182 corresponds to the first driving electrode 172, and the second touch electrode 183 corresponds to the second driving electrode 173. The third touch electrode corresponds to the third driving electrode. The first touch electrode 182 overlaps the first driving electrode 172, and the second touch electrode 183 overlaps the second driving electrode 173. The third touch electrode overlaps the third driving electrode.

A width of the first touch electrode 182 is equal to or greater than that of the first driving electrode 172, and a width of the second touch electrode 183 is equal to or greater than that of the second driving electrode 173. A width of the third touch electrode is equal to or greater than that of the third driving electrode. In an exemplary embodiment of the present disclosure, the width of the first touch electrode 182 may be greater than that of the first driving electrode 172, and the width of the second touch electrode 183 may be greater than that of the second driving electrode 173. The width of the third touch electrode may be greater than that of the third driving electrode.

A center of the first touch electrode 182 is positioned in the first non-emission area NEA1, and both ends of the first touch electrode 182 may extend into a portion of the first emission area EA1 and a portion of the second emission area EA2, respectively. A center of the second touch electrode 183 is positioned in the second non-emission area NEA2, and both ends of the second touch electrode 183 may extend into a portion of the second emission area EA2 and a portion of the third emission area EA3, respectively. A center of the third touch electrode is positioned in the third non-emission area, and both ends of the third touch electrode may extend into a portion of the first emission area EA1 and a portion of the third emission area EA3, respectively.

Each of the first and second touch electrodes 182 and 183 is formed of a conductive material. For example, each of the first and second touch electrodes 182 and 183 may be formed of at least one of molybdenum (Mo), aluminum (Al), chromium (Cr), gold (Au), titanium (Ti), nickel (Ni), neodymium (Nd), copper (Cu), indium-tin-oxide (ITO), indium-zinc-oxide (IZO), indium-tin-zinc oxide (ITZO), tin oxide (SnO), zinc oxide (ZnO), indium-copper-oxide (ICO), and aluminum:zinc oxide (Al:ZnO; AZO). In an exemplary embodiment of the present disclosure, each of the first and second touch electrodes 182 and 183 may be formed of a transparent conductive material.

The transmittance variable touch panel 170 may further include a touch buffer layer 186 covering the first and second touch electrodes 182 and 183 and a bridge electrode 188 positioned on the touch buffer layer 186 and connected to the second touch electrode 183. The bridge electrode 188 may contact the second touch electrode 183 through a contact hole in the touch buffer layer 186.

The touch buffer layer 186 may be formed of an inorganic insulating material, *e.g.,* silicon oxide or silicon nitride.

The bridge electrode 188 is formed of a conductive material. For example, the bridge electrode 188 may be formed of at least one of molybdenum (Mo), aluminum (Al), chromium (Cr), gold (Au), titanium (Ti), nickel (Ni), neodymium (Nd), copper (Cu), indium-tin-oxide (ITO), indium-zinc-oxide (IZO), indium-tin-zinc oxide (ITZO), tin oxide (SnO), zinc oxide (ZnO), indium-copper-oxide (ICO), and aluminum:zinc oxide (Al:ZnO; AZO). In an exemplary embodiment of the present disclosure, the bridge electrode 188 may be formed of a transparent conductive material.

Referring to FIGs. 3A and 4, in a first driving mode, in which the light emitting diode D is on, no voltage difference occurs between the driving electrode layer 171 and the touch electrode layer 181 so that the light absorption layer 178 can be positioned in the space between adjacent two of the first to third spacers 180a, 180b and 180c, *i.e.,* the first non-emission area NEA1, the second non-emission area NEA2 and the third non-emission area.

In other words, the first light absorbing layer 178a may be positioned between the first driving electrode 172 and the first touch electrode 182 in the first non-emission area NEA1 and on the first driving electrode 172, and the second light absorbing layer 178b may be positioned between the second driving electrode 173 and the second touch electrode 183 in the second non-emission area NEA2 and on the second driving electrode 173.

As a result, in the first driving mode, the transparent variable touch panel 170 or the light emitting diode display device 100 has a relatively high transmittance in each of the first to third emission areas EA1, EA2 and EA3 and a relatively low transmittance in each of the first and second non-emission areas NEA1 and NEA2. Accordingly, the light from the light emitting diode D of the display panel 101 can be displayed in the first to third emission areas EA1, EA2 and EA3 without brightness degradation.

Referring to FIGs. 3B and 4, in a second driving mode, in which the light emitting diode D is off, a voltage difference occurs between the driving electrode layer 171 and the touch electrode layer 181 so that the light absorption layer 178 can cover the side surface of the first to third spacers 180a, 180b and 180c. Namely, in the second driving mode, the light absorbing layer 178 may be positioned in the first to third emission areas EA1, EA2 and EA3.

In other words, the first light absorbing layer 178a may cover one side surface of the first spacer 180a and one side surface of the second spacer 180b, and the second light absorbing layer 178b may cover the other side surface of the second spacer 180b and one side surface of the third spacer 180c.

As a result, in the second driving mode, the transmittance variable touch panel 170 or the light emitting diode display device 100 has a relatively low transmittance in each of the first to third emission areas EA1, EA2 and EA3 and a relatively high transmittance in each of the first and second non-emission areas NEA1 and NEA2. Accordingly, the ambient light reflection in the light emitting diode display device 100 can be minimized.

Namely, in the first driving mode, the light absorbing layer 178 is positioned in the first and second non-emission areas NEA1 and NEA2 so that the transmittance variable layer 175 may have a first transmittance in each of the first to third emission areas EA1, EA2 and EA3. In the second driving mode, the light absorbing layer 178 covers the side surface of the first to third spacers 180a, 180b and 180c so that the transmittance variable layer 175 may have a second transmittance, which is smaller than the first transmittance, in each of the first to third emission areas EA1, EA2 and EA3.

In addition, in the first driving mode, the light absorbing layer 178 is positioned in the first and second non-emission areas NEA1 and NEA2 so that the transmittance variable layer 175 may have a third transmittance in each of the first and second non-emission areas NEA1 and NEA2. In the second driving mode, the light absorbing layer 178 covers the side surface of the first to third spacers 180a, 180b and 180c so that the transmittance variable layer 175 may have a fourth transmittance, which is greater than the third transmittance, in each of the first and second non-emission areas NEA1 and NEA2.

In an exemplary embodiment of the present disclosure, in the second driving mode, the light absorbing layer 178 may cover the side surface of the first to third spacers 180a, 180b and 180c and fill a space between the first to third spacers 180a, 180b and 180c. In this case, in each of the first and second non-emission areas NEA1 and NEA2, the transmittance of the transmittance variable layer 175 in the second driving mode may be substantially same as the transmittance of the transmittance variable layer 175 in the first driving mode.

A thickness of the spacer 180 may be equal to or smaller than a distance between the driving electrode layer 171 and the touch electrode layer 181. In an exemplary embodiment of the present disclosure, the thickness of the spacer 180 may be smaller than the distance between the driving electrode layer 171 and the touch electrode layer 181. When the thickness of the spacer 180 is smaller than the distance between the driving electrode layer 171 and the touch electrode layer 181, the light absorbing layer 178 can cover an upper end of the spacer 170 in the second driving mode so that the transmittance of the transmittance variable touch panel 180 in the second driving mode can be minimized.

The second buffer layer 166 is disposed on the bridge electrode 188, and the color filter panel 190 is disposed on the second buffer layer 166.

The color filter panel 190 may include a black matrix 191 corresponding to the non-emission areas NEA1 and NEA2 and a color filter layer 194 corresponding to the emission areas EA1, EA2 and EA3.

The black matrix 191 may include a first black matrix 192 corresponding to the first non-emission area NEA1 and a second black matrix 193 corresponding to the second non-emission area NEA2. Each of the first and second black matrixes 192 and 193 may correspond to a boundary of the pixel region P.

A width of the black matrix 191 may be smaller than that of the bank 156. Namely, the bank 156 may have a first opening in correspondence to each of the emission areas EA1, EA2 and EA3, and the black matrix 191 may have a second opening in correspondence to each of the emission areas EA1, EA2 and EA3. In this case, a width (or an area) of the first opening may be smaller than that of the second opening.

A distance between adjacent spacers 180 may be equal to or smaller than a distance between adjacent black matrixes 191. Namely, a width of each of the first and second driving electrodes 172 and 173 may be equal to or smaller than that of the black matrix 191. In an exemplary embodiment of the present disclosure, the distance between adjacent spacers 180 may be smaller than the distance between adjacent black matrixes 191.

A width of each of the first and second touch electrodes 182 and 183 may be equal to or greater than that of the black matrix 191. In an exemplary embodiment of the present disclosure, the width of the black matrix 191 may be smaller than that of each of the first and second touch electrode 182 and 183 and greater than that of each of the first and second driving electrodes 172 and 173.

The color filter layer 194 is positioned between adjacent black matrixes 191. The color filter layer 194 may include a first color filter pattern 195 corresponding to the first emission area EA1, a second color filter pattern 196 corresponding to the second emission area EA2 and a third color filter pattern 197 corresponding to the third emission area EA3.

The first color filter pattern 195 may be a red color filter pattern and include a red dye or a red pigment. The second color filter pattern 196 may be a green color filter pattern and include a green dye or a green pigment. The third color filter pattern 197 may be a blue color filter pattern and include a blue dye or a blue pigment.

The color filter panel 190 may further include a protection layer 198 covering the black matrix 191 and the color filter layer 194. The protection layer 198 may be formed of an inorganic insulating material, *e.g.,* silicon oxide or silicon nitride, or an organic insulating material, *e.g.,* photo-acryl or benzocyclobutene.

The light emitting diode display device 100 according to the first embodiment of the present disclosure includes the transmittance variable touch panel 170 disposed over the display panel 101 and being capable of controlling a transmittance so that an ambient light reflection can be minimized without brightness degradation.

Namely, the light absorbing layer 178 in the first driving mode is positioned in the non-emission areas NEA1 and NEA2, and the light absorbing layer 178 in the second driving mode covers a side surface of the spacer 180 positioned in the emission areas EA1, EA2 and EA3. Accordingly, the brightness of the emission areas EA1, EA2 and EA3 in the first driving mode is not decreased, and the ambient light reflection of the emission areas EA1, EA2 and EA3 in the second driving mode can be reduced.

In addition, since the light absorbing layer 178 can be driven by using the touch electrode layer 181, an addition of additional elements for reducing the ambient light reflection can be minimized.

Moreover, when a thickness of the spacer 180 is smaller than a distance between the driving electrode layer 171 and the touch electrode layer 181, the light absorbing layer 178 covers an upper end of the spacer 180 so that the ambient light reflection can be further reduced.

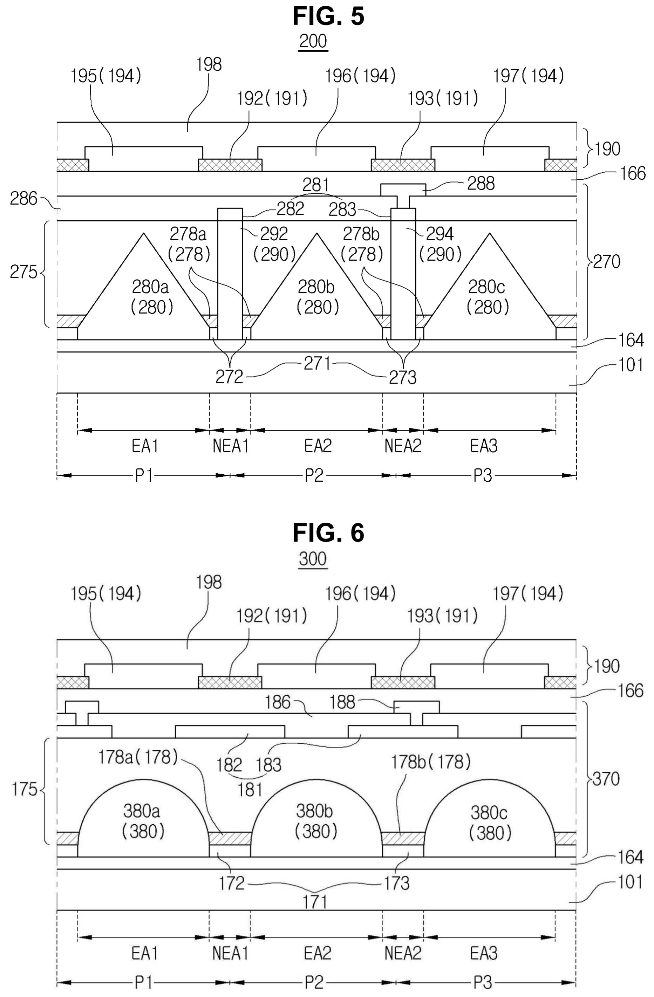

FIG. 5 is a schematic cross-section view of an organic light emitting display device according to a second embodiment of the present disclosure.

As shown in FIG. 5, a light emitting diode display device 200 includes a display panel 101 and a transmittance variable touch panel 270 disposed over the display panel 101.

The display panel 101 may be an organic light emitting diode display panel or an inorganic light emitting diode display panel.

In addition, the light emitting diode display device 200 may further include a color filter panel 190 disposed over the transmittance variable touch panel 270. Namely, the transmittance variable touch panel 270 may be positioned between the display panel 101 and the color filer panel 190.

Moreover, the light emitting diode display device 200 may further include at least one of a first buffer layer 164 between the display panel 101 and the transmittance variable touch panel 270 and a second buffer layer 166 between the transmittance variable touch panel 270 and the color filter panel 290.

The light emitting diode display device 200 according to the second embodiment of the present disclosure has a difference in a configuration of the transmittance variable touch panel 270 from the light emitting diode display device 100 according to the first embodiment of the present disclosure. The description is focused on the transmittance variable touch panel 270.

The transmittance variable touch panel 270 includes a transmittance variable layer 275 including a spacer 280 and a light absorbing layer 278, a driving electrode layer 271, a touch electrode layer 281 and a partition wall 290.

The spacer 280 includes a first spacer 280a in the first emission area EA1, a second spacer 280b in the second emission area EA2 and a third spacer 280c in the third emission area EA3.

The partition wall 290 is disposed in the non-emission areas NEA1 and NEA2. Namely, the partition wall 290 is positioned between adjacent spacers 280.

The partition wall 290 includes a first partition wall 292 in the first non-emission area NEA1 and a second partition wall 294 in the second non-emission area NEA2. The first partition wall 292 is positioned between the first and second spacers 280a and 280b and spaced apart from the first and second spacers 280a and 280b. The second partition wall 294 is positioned between the second and third spacers 280b and 280c and spaced apart from the second and third spacers 280b and 280c.

The partition wall 290 may be formed of the same material as the spacer 280. In addition, the partition wall 290 and the spacer 280 may be formed by the same process. For example, each of the partition wall 290 and the spacer 280 may be formed of an organic material, e.g., acryl resin, epoxy resin, phenolic resin, polyamide resin or polyimide resin.

The light absorbing layer 278 is disposed in a space between the spacer 280 and the partition wall 290 or at a side surface of each of the first to third spacers 280a, 280b and 280c. Namely, the light absorbing layer 278 is positioned in the first non-emission area NEA1, the second non-emission area NEA2 and the third non-emission area or covers the side surface of each of the first to third spacers 280a, 280b and 280c.

The light absorbing layer 278 includes a charged black particle. The light absorbing layer 278 is positioned in the emission areas EA1, EA2 and EA3 or the non-emission areas NEA1 and NEA2 according to the operation (or drive) of the transmittance variable touch panel 270 so that the transmittance of the transmittance variable touch panel 270 and the light emitting diode display device 200 can be controlled.

The light absorbing layer 278 may include a first light absorbing layer 278a positioned i) in the first non-emission area NEA1 between the first spacer 280a and the first partition wall 292 and in the first non-emission area NEA1 between the second spacer 280b and the first partition wall 292 or ii) one side surface of the first spacer 280a and one side surface of the second spacer 280b and a second light absorbing layer 278b positioned i) in the second non-emission area NEA2 between the second spacer 280b and the second partition wall 294 and in the second non-emission area NEA2 between the third spacer 280c and the second partition wall 294 or ii) one side surface of the second spacer 280b and one side surface of the third spacer 280c.

The first light absorbing layer 278a is positioned at both sides of the first partition wall 292, and the second light absorbing layer 278b is positioned at both sides of the second partition wall 294. Namely, the first light absorbing layer 278a may be divided into two parts by the first partition wall 292, and the second light absorbing layer 278b may be divided into two parts by the second partition wall 294.

The driving electrode layer 271 is positioned at one side of the transmittance variable layer 275. For example, the driving electrode layer 271 may be positioned at a lower side of the transmittance variable layer 275.

The driving electrode layer 271 is positioned on the first buffer layer 164 and in the non-emission areas NEA1 and NEA2. The driving electrode layer 271 may include a first driving electrode 272 positioned in the first non-emission area NEA1 and a second driving electrode 273 positioned in the second non-emission area NEA2. The driving electrode layer 271 may further include a third driving electrode positioned in the third non-emission area. The driving electrode layer 271 is positioned under the light absorbing layer 278 and overlaps the light absorbing layer 278.

The first driving electrode 272 is positioned in the first non-emission area NEA1 between the first spacer 280a and the first partition wall 292 and in the first non-emission area NEA1 between the second spacer 280b and the first partition wall 292. The second first driving electrode 274 is positioned in the second non-emission area NEA2 between the second spacer 280b and the second partition wall 294 and in the second non-emission area NEA2 between the third spacer 280c and the second partition wall 294.

The first driving electrode 272 is positioned at both sides of the first partition wall 292, and the second driving electrode 274 is positioned at both sides of the second partition wall 294. Namely, the first driving electrode 272 may be divided into two parts by the first partition wall 292, and the second driving electrode 274 may be divided into two parts by the second partition wall 294.

In other words, each of the light absorbing layer 278 and the driving electrode layer 271 may include a first opening in the emission areas EA1, EA2 and EA3 and a second opening in the non-emission areas NEA1 and NEA2. The first opening may correspond to the spacer 280, and the second opening may correspond to the partition wall 290.

The touch electrode layer 281 is positioned at the other side of the transmittance variable layer 275. For example, the touch electrode layer 281 may be positioned at an upper side of the transmittance variable layer 275.

The touch electrode layer 281 may be positioned on the partition wall 290. Namely, the touch electrode layer 281 may be positioned in the non-emission areas NEA1 and NEA2, and a space between the touch electrode layer 281 may correspond to the spacer 280.

The touch electrode layer 281 may include a first touch electrode 282 in the first non-emission area NEA1 and a second touch electrode 283 in the second non-emission area NEA2. The touch electrode layer 281 may further include a third touch electrode in the third non-emission area.

The first touch electrode 282 may correspond to the first opening in the first driving electrode 272 and the first light absorbing layer 278a and may have substantially the same area as the first opening. The second touch electrode 284 may correspond to the second opening in the second driving electrode 274 and the second light absorbing layer 278b and may have substantially the same area as the second opening.

In an embodiment of the present disclosure, the first touch electrode 282 may have an area larger than the first partition wall 292 to overlap the first driving electrode 272, and the second touch electrode 284 may have an area larger than the second partition wall 294 to overlap the second driving electrode 274.

The transmittance variable touch panel 270 may further include a touch buffer layer 286 covering the first and second touch electrodes 282 and 283 and a bridge electrode 288 positioned on the touch buffer layer 286 and connected to the second touch electrode 283. The bridge electrode 288 may contact the second touch electrode 283 through a contact hole in the touch buffer layer 286.

In a first driving mode, in which the light emitting diode D (of FIG. 4) is on, no voltage difference occurs between the driving electrode layer 271 and the touch electrode layer 281 so that the light absorption layer 278 can be positioned in the space between the spacer 280 and the partition wall 290, *i.e.,* the first non-emission area NEA1, the second non-emission area NEA2 and the third non-emission area.

In other words, the first light absorbing layer 278a may be positioned between the first driving electrode 272 and the first touch electrode 282 in the first non-emission area NEA1 and on the first driving electrode 272, and the second light absorbing layer 278b may be positioned between the second driving electrode 273 and the second touch electrode 283 in the second non-emission area NEA2 and on the second driving electrode 273.

As a result, in the first driving mode, the transmittance variable touch panel 270 or the light emitting diode display device 200 has a relatively high transmittance in each of the first to third emission areas EA1, EA2 and EA3 and a relatively low transmittance in each of the first and second non-emission areas NEA1 and NEA2. Accordingly, the light from the light emitting diode D of the display panel 101 can be displayed in the first to third emission areas EA1, EA2 and EA3 without brightness degradation.

In a second driving mode, in which the light emitting diode D is off, a voltage difference occurs between the driving electrode layer 271 and the touch electrode layer 281 so that the light absorption layer 278 can cover the side surface of the first to third spacers 280a, 280b and 280c. Namely, in the second driving mode, the light absorbing layer 278 may be positioned in the first to third emission areas EA1, EA2 and EA3.

In other words, the first light absorbing layer 278a may cover one side surface of the first spacer 280a and one side surface of the second spacer 280b, and the second light absorbing layer 278b may cover the other side surface of the second spacer 280b and one side surface of the third spacer 280c.

In addition, in the second driving mode, at least a portion of the first light absorbing layer 278a may cover the first driving electrode 272, and at least a portion of the second light absorbing layer 278b may cover the second driving electrode 274.

As a result, in the second driving mode, the transmittance variable touch panel 270 or the light emitting diode display device 200 has a relatively low transmittance in each of the first to third emission areas EA1, EA2 and EA3 and a relatively high transmittance in each of the first and second non-emission areas NEA1 and NEA2. Accordingly, the ambient light reflection in the light emitting diode display device 200 can be minimized.

Namely, in the first driving mode, the light absorbing layer 278 is positioned in the first and second non-emission areas NEA1 and NEA2 so that the transmittance variable layer 275 may have a first transmittance in each of the first to third emission areas EA1, EA2 and EA3. In the second driving mode, the light absorbing layer 278 covers the side surface of the first to third spacers 280a, 280b and 280c so that the transmittance variable layer 275 may have a second transmittance, which is smaller than the first transmittance, in each of the first to third emission areas EA1, EA2 and EA3.

In addition, in the first driving mode, the light absorbing layer 278 is positioned in the first and second non-emission areas NEA1 and NEA2 so that the transmittance variable layer 275 may have a third transmittance in each of the first and second non-emission areas NEA1 and NEA2. In the second driving mode, the light absorbing layer 278 covers the side surface of the first to third spacers 280a, 280b and 280c so that the transmittance variable layer 275 may have a fourth transmittance, which is greater than the third transmittance, in each of the first and second non-emission areas NEA1 and NEA2.

In an exemplary embodiment of the present disclosure, in the second driving mode, the light absorbing layer 278 may cover the side surface of the first to third spacers 280a, 280b and 280c and fill a space between the first to third spacers 280a, 280b and 280c. In this case, in each of the first and second non-emission areas NEA1 and NEA2, the transmittance of the transmittance variable layer 275 in the second driving mode may be substantially same as the transmittance of the transmittance variable layer 275 in the first driving mode.

A thickness of the spacer 280 may be equal to or smaller than a distance between the driving electrode layer 271 and the touch electrode layer 281. In an exemplary embodiment of the present disclosure, the thickness of the spacer 280 may be smaller than the distance between the driving electrode layer 271 and the touch electrode layer 281. When the thickness of the spacer 280 is smaller than the distance between the driving electrode layer 271 and the touch electrode layer 281, the light absorbing layer 278 can cover an upper end of the spacer 280 in the second driving mode so that the transmittance of the transmittance variable touch panel 280 in the second driving mode can be minimized.

A width of the black matrix 291 may be smaller than that of the bank 256. Each of a distance between adjacent spacers 280 and a width of the partition wall 290 may be equal to or smaller than a width of the black matrix 291. In an embodiment of the present disclosure, each of the distance between adjacent spacers 280 and the width of the partition wall 290 may be smaller than the width of the black matrix 291.

The light emitting diode display device 200 according to the second embodiment of the present disclosure includes the transmittance variable touch panel 270 disposed over the display panel 101 and being capable of controlling a transmittance so that an ambient light reflection can be minimized without brightness degradation.

Namely, the light absorbing layer 278 in the first driving mode is positioned in the non-emission areas NEA1 and NEA2, and the light absorbing layer 278 in the second driving mode covers a side surface of the spacer 280 positioned in the emission areas EA1, EA2 and EA3. Accordingly, the brightness of the emission areas EA1, EA2 and EA3 in the first driving mode is not decreased, and the ambient light reflection of the emission areas EA1, EA2 and EA3 in the second driving mode can be reduced.

In addition, since the light absorbing layer 278 can be driven by using the touch electrode layer 281, an addition of additional elements for reducing the ambient light reflection can be minimized.

Moreover, since the light absorbing layer 278 is divided by the partition wall 290, an amount of the light absorbing layer 278 in each pixel region can be maintained. Accordingly, a deviation of ambient light reflection property in the pixel regions can be prevented.

Furthermore, when a thickness of the spacer 280 is smaller than a distance between the driving electrode layer 271 and the touch electrode layer 281, the light absorbing layer 278 covers an upper end of the spacer 280 so that the ambient light reflection can be further reduced.

FIG. 6 is a schematic cross-section view illustrating the light emitting diode display device according to a third embodiment of the present disclosure.

As shown in FIG. 6, the light emitting diode display device 300 includes a display panel 101 and a transmittance variable touch panel 370 disposed over the display panel 101.

The display panel 101 may be an organic light emitting diode display panel or an inorganic light emitting diode display panel.

In addition, the light emitting diode display device 300 may further include a color filter panel 190 disposed over the transmittance variable touch panel 370. Namely, the transmittance variable touch panel 370 may be positioned between the display panel 101 and the color filer panel 190.

Moreover, the light emitting diode display device 300 may further include at least one of a first buffer layer 164 between the display panel 101 and the transmittance variable touch panel 370 and a second buffer layer 166 between the transmittance variable touch panel 370 and the color filter panel 190.

The light emitting diode display device 300 according to the third embodiment of the present disclosure has a difference in a configuration of a spacer 380 of the transmittance variable touch panel 370 from the light emitting diode display device 100 according to the first embodiment of the present disclosure. The description is focused on the spacer 380 of the transmittance variable touch panel 370.

The transmittance variable touch panel 370 includes a transmittance variable layer 175 including a spacer 380 and a light absorbing layer 178, a driving electrode layer 171 and a touch electrode layer 181.

The spacer 380 includes a first spacer 380a in the first emission area EA1, a second spacer 380b in the second emission area EA2 and a third spacer 380c in the third emission area EA3. The first to third spacers 380a, 380b and 380c are spaced apart from each other. A space between the first and second spacers 380a and 380b corresponds to the first non-emission area NEA1, and a spacer between the second and third spacers 380b and 380c corresponds to the second non-emission area NEA2.

Each of the first to third spacers 380a, 380b and 380c has a lower portion having a first width and an upper portion having a second width. The second width is smaller than the first width. For example, each of the first to third spacers 180a, 180b and 180c may have a dome shape (*e.g.,* a lens shape). Accordingly, the light from the display panel 101 is concentrated so that the optical efficiency in the first to third emission areas EA1, EA2 and EA3 can be improved.

The light emitting diode display device 300 according to the third embodiment of the present disclosure includes the transmittance variable touch panel 370 disposed over the display panel 101 and being capable of controlling a transmittance so that an ambient light reflection can be minimized without brightness degradation.

Namely, the light absorbing layer 178 of the transmittance variable touch panel 370 in the first driving mode is positioned in the non-emission areas NEA1 and NEA2, and the light absorbing layer 178 of the transmittance variable touch panel 370 in the second driving mode covers a side surface of the spacer 380 positioned in the emission areas EA1, EA2 and EA3. Accordingly, the brightness of the emission areas EA1, EA2 and EA3 in the first driving mode is not decreased, and the ambient light reflection of the emission areas EA1, EA2 and EA3 in the second driving mode can be reduced.

In addition, since the light absorbing layer 178 can be driven by using the touch electrode layer 181, an addition of additional elements for reducing the ambient light reflection can be minimized.

Moreover, since the spacer 380 has a dome shape (*e.g.,* a lens shape), the light from the display panel 101 is concentrated so that the optical efficiency in the first to third emission areas EA1, EA2 and EA3 can be improved.

Furthermore, when a thickness of the spacer 380 is smaller than a distance between the driving electrode layer 171 and the touch electrode layer 181, the light absorbing layer 178 covers an upper end of the spacer 380 so that the ambient light reflection can be further reduced.

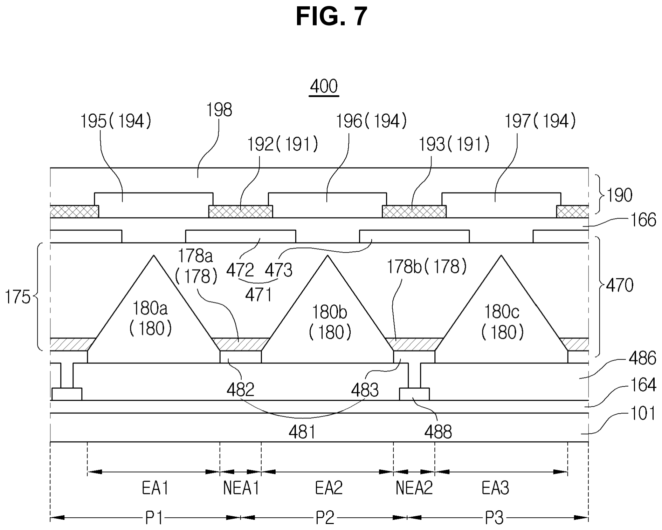

FIG. 7 is a schematic cross-section view illustrating the light emitting diode display device according to a fourth embodiment of the present disclosure.

As shown in FIG. 7, the light emitting diode display device 400 includes a display panel 101 and a transmittance variable touch panel 470 disposed over the display panel 101.

The display panel 101 may be an organic light emitting diode display panel or an inorganic light emitting diode display panel.

In addition, the light emitting diode display device 400 may further include a color filter panel 190 disposed over the transmittance variable touch panel 470. Namely, the transmittance variable touch panel 470 may be positioned between the display panel 101 and the color filer panel 190.

Moreover, the light emitting diode display device 400 may further include at least one of a first buffer layer 164 between the display panel 101 and the transmittance variable touch panel 470 and a second buffer layer 166 between the transmittance variable touch panel 470 and the color filter panel 190.

The light emitting diode display device 400 according to the fourth embodiment of the present disclosure has a difference in a configuration of a driving electrode layer 471 and a touch electrode layer 481 of the transmittance variable touch panel 470 from the light emitting diode display device 100 according to the first embodiment of the present disclosure. The description is focused on the driving electrode layer 471 and the touch electrode layer 481 of the transmittance variable touch panel 470.

The touch electrode layer 481 is positioned at one side of the transmittance variable layer 175. For example, the touch electrode layer 481 may be positioned at a lower side of the transmittance variable layer 175.

The touch electrode layer 481 is positioned on the first buffer layer 164 and in the non-emission areas NEA1 and NEA2. The touch electrode layer 481 may include a first touch electrode 482 positioned in the first non-emission area NEA1 and a second touch electrode 483 positioned in the second non-emission area NEA2. The touch electrode layer 481 may further include a third touch electrode in the third non-emission area.

The driving electrode layer 471 is positioned at the other one side of the transmittance variable layer 175. For example, the driving electrode layer 471 may be positioned at an upper side of the transmittance variable layer 175.

The driving electrode layer 471 is positioned in the non-emission areas NEA1 and NEA2. The driving electrode layer 471 may include a first driving electrode 472 positioned in the first non-emission area NEA1 and a second driving electrode 473 positioned in the second non-emission area NEA2. The driving electrode layer 471 may further include a third driving electrode in the third non-emission area.

The first driving electrode 472 corresponds to the first touch electrode 482, and the second driving electrode 473 corresponds to the second touch electrode 483. The first driving electrode 472 overlaps the first touch electrode 482, and the second driving electrode 473 overlaps the second touch electrode 483. The third driving electrode may correspond to the third touch electrode. The third driving electrode overlaps the third touch electrode.

A width of the first driving electrode 472 may be equal to or greater than that of the first touch electrode 482, and a width of the second driving electrode 473 may be equal to or greater than that of the second touch electrode 483. In an exemplary embodiment of the present disclosure, the width of the first driving electrode 472 may be greater than that of the first touch electrode 482, and the width of the second driving electrode 473 may be greater than that of the second touch electrode 483. A width of the third driving electrode may be equal to or greater than that of the third touch electrode. In an exemplary embodiment of the present disclosure, the width of the third driving electrode may be greater than that of the third touch electrode.

A center of the first driving electrode 472 may be positioned in the first non-emission area NEA1, and both ends of the first driving electrode 472 may extends into a portion of the first emission area EA1 and a portion of the second emission area EA2, respectively. A center of the second driving electrode 473 may be positioned in the first non-emission area NEA1, and both ends of the second driving electrode 473 may extends into a portion of the first emission area EA1 and a portion of the second emission area EA2, respectively. A center of the third driving electrode may be positioned in the first non-emission area NEA1, and both ends of the third driving electrode may extends into a portion of the first emission area EA1 and a portion of the second emission area EA2, respectively.

The transmittance variable touch panel 470 may further include a bridge electrode 488 under the touch electrode layer 481 and a touch buffer layer 486 between the touch electrode layer 481 and the bridge electrode 488. The second touch electrode 483 may be connected to the bridge electrode 488 through a contact hole formed in the touch buffer layer 486.

A width of each of the first and second touch electrodes 482 and 483 may be equal to or smaller than that of the black matrix 191. A width of each of the first and second driving electrodes 472 and 473 may be equal to or greater than that of the black matrix 191. In an exemplary embodiment of the present disclosure, the width of the black matrix 191 may be smaller than that of each of the first and second driving electrodes 472 and 473 and greater than that of each of the first and second touch electrodes 482 and 483.

The light emitting diode display device 400 according to the fourth embodiment of the present disclosure includes the transmittance variable touch panel 470 disposed over the display panel 101 and being capable of controlling a transmittance so that an ambient light reflection can be minimized without brightness degradation.

Namely, the light absorbing layer 178 of the transmittance variable touch panel 470 in the first driving mode is positioned in the non-emission areas NEA1 and NEA2, and the light absorbing layer 178 of the transmittance variable touch panel 470 in the second driving mode covers a side surface of the spacer 180 positioned in the emission areas EA1, EA2 and EA3. Accordingly, the brightness of the emission areas EA1, EA2 and EA3 in the first driving mode is not decreased, and the ambient light reflection of the emission areas EA1, EA2 and EA3 in the second driving mode can be reduced.

In addition, since the light absorbing layer 178 can be driven by using the touch electrode layer 481, an addition of additional elements for reducing the ambient light reflection can be minimized.

Moreover, when a thickness of the spacer 180 is smaller than a distance between the driving electrode layer 471 and the touch electrode layer 481, the light absorbing layer 178 covers an upper end of the spacer 180 so that the ambient light reflection can be further reduced.

In sum, the present disclosure describes a light emitting diode display device with a transmittance variable touch panel that dynamically controls light transmission to reduce ambient light reflection without reducing display brightness. When the display is on, a light absorbing layer containing charged black particles remains in non-emission areas, allowing full brightness in active pixels. When the display is off, the particles shift to cover emission areas under an applied voltage, minimizing reflections. This dual mode operation enables clear images in bright environments while preserving energy efficiency and image quality.

The structure includes spacers with specialized shapes such as triangular cones or dome and lens forms that not only separate electrodes but also focus light to improve optical efficiency. Partition walls in some embodiments maintain uniform distribution of absorbing particles across pixels, ensuring consistent anti reflection performance. In addition, the touch electrode layer also functions as the control mechanism for the absorbing particles, avoiding the need for separate optical and touch components and simplifying the design.

The design supports both OLED and inorganic LED technologies, including quantum dot displays, and integrates multiple optical layers such as black matrixes, color filters, and encapsulation layers for improved contrast and durability. Overall, the structure combines light management, touch sensing, and optical efficiency into a single system, making it suitable for high performance, low reflection display panels.

The following examples pertain to further embodiments:
Example 1: A light emitting diode display device, comprising: a display panel including first, second, and third pixel regions and a light emitting diode in each of a first emission area of the first pixel region, a second emission area of the second pixel region, and a third emission area of the third pixel region; a transmittance variable layer disposed on the display panel and including first, second, and third spacers and a light absorbing layer in a space between the first to third spacers or at a side surface of each of the first to third spacers, the first to third spacers respectively disposed in the first, second, and third emission areas; a driving electrode layer disposed at one side of the transmittance variable layer and including a first driving electrode in a first non-emission area between the first and second emission areas and a second driving electrode in a second non-emission area between the second and third emission areas; and a touch electrode layer disposed at the other side of the transmittance variable layer and including a first touch electrode corresponding to the first driving electrode and a second touch electrode corresponding to the second driving electrode.
Example 2: The light emitting diode display device according to Example 1, wherein the first and second driving electrodes are positioned between the display panel and the transmittance variable layer, and wherein the first touch electrode has a width being greater than a width of the first driving electrode, and the second touch electrode has a width being greater than a width of the second driving electrode.
Example 3: The light emitting diode display device according to Example 1 or 2, further comprising: a first partition wall in the first non-emission area; and a second partition wall in the second non-emission area, wherein the first driving electrode is positioned at both sides of one end of the first partition wall, and the second driving electrode is positioned at both sides of one end of the second partition wall.
Example 4: The light emitting diode display device according to Example 3, wherein the light absorbing layer includes: a first light absorbing layer disposed between the first spacer and the first partition wall, and between the second spacer and the first partition wall, and a second light absorbing layer disposed between the second spacer and the second partition wall, and between the third spacer and the second partition wall.
Example 5: The light emitting diode display device according to Example 3, further comprising: first and second black matrixes disposed on the transmittance variable layer and in the first and second non-emission areas, respectively; and first, second, and third color filter patterns disposed on the transmittance variable layer and in the first, second, and third emission areas, respectively, wherein the first partition wall has a width being smaller than a width of the first black matrix, and the second partition wall has a width being smaller than a width of the second black matrix.
Example 6: The light emitting diode display device according to any of Examples 1 to 5, wherein each of the first to third spacers has a dome shape.
Example 7: The light emitting diode display device according to Example 1, wherein the first and second touch electrodes are positioned between the display panel and the transmittance variable layer, and wherein the first driving electrode has a width being greater than a width of the first touch electrode, and the second driving electrode has a width being greater than a width of the second touch electrode.
Example 8: The light emitting diode display device according to any of Examples 1 to 7, wherein in a first driving mode, the light absorbing layer is positioned in the first and second non-emission areas, and the transmittance variable layer has a first transmittance in each of the first to third emission areas, wherein in a second driving mode, the light absorbing layer covers a side surface of each of the first to third spacers, and the transmittance variable layer has a second transmittance in each of the first to third emission areas, and wherein the second transmittance is smaller than the first transmittance.
Example 9: The light emitting diode display device according to Example 8, wherein in the first driving mode, the light emitting diode is on, and wherein in the second driving mode, the light emitting diode is off.
Example 10: The light emitting diode display device according to any of Examples 1 to 9, wherein in a first driving mode, the light absorbing layer is positioned in the first and second non-emission areas, and the transmittance variable layer has a third transmittance in each of the first and second non-emission areas, wherein in a second driving mode, the light absorbing layer covers a side surface of each of the first to third spacers, and the transmittance variable layer has a fourth transmittance in each of the first and second non-emission areas, and wherein the fourth transmittance is greater than the third transmittance.
Example 11: The light emitting diode display device according to Example 10, wherein in the first driving mode, the light emitting diode is on, and wherein in the second driving mode, the light emitting diode is off.
Example 12: The light emitting diode display device according to any of Examples 1 to 11, further comprising: a bridge electrode disposed under or on the touch electrode layer and connected to the first touch electrode or the second touch electrode.
Example 13: The light emitting diode display device according to any of Examples 1 to 4, further comprising: first and second black matrixes disposed on the transmittance variable layer and in the first and second non-emission areas, respectively; and first, second and third color filter layers disposed on the transmittance variable layer and in the first, second and third emission areas, respectively.
Example 14: The light emitting diode display device according to Example 13, further comprising: a first bank in the first non-emission area; and a second bank in the second non-emission area.
Example 15: The light emitting diode display device according to Example 14, wherein the first bank has a width being greater than a width of the first black matrix, and the second bank has a width being greater than a width of the second black matrix.
Example 16: The light emitting diode display device according to Example 15, wherein a distance between the first and second spacers is equal to or smaller than a width of the first black matrix.
Example 17: The light emitting diode display device according to Example 15 or 16, wherein the first driving electrode has a width being equal to or smaller than a width of the first black matrix, and the second driving electrode has a width being equal to or smaller than a width of the second black matrix.
Example 18: The light emitting diode display device according to any of Examples 15 to 17, wherein the first touch electrode has a width being equal to or smaller than a width of the first black matrix, and the second touch electrode has a width being equal to or smaller than a width of the second black matrix.
Example 19: The light emitting diode display device according to any of Examples 1 to 18, wherein a thickness of each of the first to third spacers is equal to or smaller than a distance between the driving electrode and the touch electrode layer.
Example 20: The light emitting diode display device according to any of Examples 1 to 19, wherein the light absorbing layer includes a plurality of electrically charged black particles.

The various embodiments described above can be combined to provide further embodiments.

## Claims

1. A light emitting diode display device (100, 200, 300, 400), comprising:
a display panel (101) including first, second, and third pixel regions (P1, P2, P3) and a light emitting diode (D) in each of a first emission area (EA1) of the first pixel region (P1), a second emission area (EA2) of the second pixel region (P2), and a third emission area (EA3) of the third pixel region (P3);
a transmittance variable layer (175, 275) disposed on the display panel (101) and including first, second, and third spacers (180a, 180b, 180c; 280a, 280b, 280c; 380a, 380b, 380c) and a light absorbing layer (178, 278) in a space between the first to third spacers (180a, 180b, 180c; 280a, 280b, 280c; 380a, 380b, 380c) or at a side surface of each of the first to third spacers (180a, 180b, 180c; 280a, 280b, 280c; 380a, 380b, 380c), the first to third spacers (180a, 180b, 180c; 280a, 280b, 280c; 380a, 380b, 380c) respectively disposed in the first, second, and third emission areas (EA1, EA2, EA3);
a driving electrode layer (171, 271, 471) disposed at one side of the transmittance variable layer (175, 275) and including a first driving electrode (172, 272, 472) in a first non-emission area (NEA1) between the first and second emission areas (EA1, EA2) and a second driving electrode (173, 273, 473) in a second non-emission area (NEA2) between the second and third emission areas (EA2, EA3); and
a touch electrode layer (181, 281, 481) disposed at the other side of the transmittance variable layer (175, 275) and including a first touch electrode (182, 282, 482) corresponding to the first driving electrode (172, 272, 472) and a second touch electrode (183, 283, 483) corresponding to the second driving electrode (173, 273, 473).

2. The light emitting diode display device (100, 200, 300, 400) according to claim 1, wherein the first and second driving electrodes (172, 272, 472; 173, 273, 473) are positioned between the display panel (101) and the transmittance variable layer (175, 275), and
wherein the first touch electrode (182, 282, 482) has a width being greater than a width of the first driving electrode (172, 272, 472), and the second touch electrode (183, 283, 483) has a width being greater than a width of the second driving electrode (173, 273, 473).

3. The light emitting diode display device (200) according to claim 1 or 2, further comprising:
a first partition wall (292) in the first non-emission area (NEA1); and
a second partition wall (294) in the second non-emission area (NEA2),
wherein the first driving electrode (272) is positioned at both sides of one end of the first partition wall (292), and the second driving electrode (273) is positioned at both sides of one end of the second partition wall (294).

4. The light emitting diode display device (200) according to claim 3, wherein the light absorbing layer (278) includes:
a first light absorbing layer (278a) disposed between the first spacer (280a) and the first partition wall (292), and between the second spacer (280b) and the first partition wall (292), and
a second light absorbing layer (278b) disposed between the second spacer (280b) and the second partition wall (294), and between the third spacer (280c) and the second partition wall (294).

5. The light emitting diode display device (200) according to claim 3 or 4, further comprising:
first and second black matrixes (192, 193) disposed on the transmittance variable layer (275) and in the first and second non-emission areas (NEA1, NEA2), respectively; and
first, second, and third color filter patterns (195, 196, 197) disposed on the transmittance variable layer (175, 275) and in the first, second, and third emission areas (EA, EA2, EA3), respectively,
wherein the first partition wall (292) has a width being smaller than a width of the first black matrix (192), and the second partition wall (294) has a width being smaller than a width of the second black matrix (193).

6. The light emitting diode display device (100, 200, 300, 400) according to any of claims 1 to 5, wherein each of the first to third spacers (380a, 380b, 380c) has a dome shape.

7. The light emitting diode display device (400) according to claim 1, wherein the first and second touch electrodes (482, 483) are positioned between the display panel (101) and the transmittance variable layer (175), and
wherein the first driving electrode (472) has a width being greater than a width of the first touch electrode (482), and the second driving electrode (473) has a width being greater than a width of the second touch electrode (483).

8. The light emitting diode display device (100, 200, 300, 400) according to any of claims 1 to 7, wherein in a first driving mode, the light absorbing layer (178, 278) is positioned in the first and second non-emission areas (NEA1, NEA2), and the transmittance variable layer (175, 275) has a first transmittance in each of the first to third emission areas (EA1, EA2, EA3) and/or has a third transmittance in each of the first and second non-emission areas (NEA1, NEA2),
wherein in a second driving mode, the light absorbing layer (178, 278) covers a side surface of each of the first to third spacers (180a, 180b, 180c; 280a, 280b, 280c; 380a, 380b, 380c), and the transmittance variable layer (175, 275) has a second transmittance in each of the first to third emission areas (EA1, EA2, EA3) and/or has a fourth transmittance in each of the first and second non-emission areas (NEA1, NEA2), and
wherein the second transmittance is smaller than the first transmittance and the fourth transmittance is greater than the third transmittance.

9. The light emitting diode display device (100, 200, 300, 400) according to claim 8, wherein in the first driving mode, the light emitting diode (D) is on, and
wherein in the second driving mode, the light emitting diode (D) is off.

10. The light emitting diode display device (100, 200, 300, 400) according to any of claims 1 to 9, further comprising:
a bridge electrode (188, 288, 488) disposed under or on the touch electrode layer (181, 281, 481) and connected to the first touch electrode (182, 282, 482) or the second touch electrode (183, 283, 483).

11. The light emitting diode display device (100, 200, 300, 400) according to any of claims 1 to 4, further comprising:
first and second black matrixes (192, 193) disposed on the transmittance variable layer (175, 275) and in the first and second non-emission areas (NEA1, NEA2), respectively; and
first, second and third color filter patterns (195, 196, 197) disposed on the transmittance variable layer (175, 275) and in the first, second and third emission areas (EA1, EA2, EA3), respectively.

12. The light emitting diode display device (100, 200, 300, 400) according to claim 11, further comprising:
a first bank (156) in the first non-emission area (NEA1); and
a second bank (156) in the second non-emission area (NEA2).

13. The light emitting diode display device (100, 200, 300, 400) according to claim 12, wherein the first bank (156) has a width being greater than the first black matrix (192), and the second bank (156) has a width being greater than the second black matrix (193).

14. The light emitting diode display device (100, 200, 300, 400) according to claim 13, wherein a distance between the first and second spacers (180a, 180b, 180c; 280a, 280b, 280c; 380a, 380b, 380c) is equal to or smaller than a width of the first black matrix (192).

15. The light emitting diode display device (100, 200, 300, 400) according to claim 13 or 14, wherein:
the first driving electrode (172, 272, 472) has a width being equal to or smaller than a width of the first black matrix (192), and the second driving electrode (173, 273, 473) has a width being equal to or smaller than a width of the second black matrix (193);
and/or wherein:
the first touch electrode (182, 282, 482) has a width being equal to or smaller than a width of the first black matrix (192), and the second touch electrode (183, 283, 483) has a width being equal to or smaller than a width of the second black matrix (193).

16. The light emitting diode display device (100, 200, 300, 400) according to any of claims 1 to 15, wherein a thickness of each of the first to third spacers (180a, 180b, 180c; 280a, 280b, 280c; 380a, 380b, 380c) is equal to or smaller than a distance between the driving electrode layer (171, 271, 471) and the touch electrode layer (181, 281, 481).

17. The light emitting diode display device (100, 200, 300, 400) according to any of claims 1 to 16, wherein the light absorbing layer (178, 278) includes a plurality of electrically charged black particles.
